# EUROPEAN PATENT APPLICATION

(11) **EP 4 745 607 A1**
(43) Date of publication of application: **20.05.2026**
(21) Application number: 24213193.6
(22) Date of filing: 15.11.2024
(51) Int. Cl.: G01R 31/58, G01R 31/69

(54) **METHOD FOR TESTING A WIRE HARNESS**

(71) Applicant: Komax Testing Germany GmbH, 32457 Porta Westfalica (DE)
(72) Inventor: Nagel, Norman, 32457 Porta Westfalica (DE); Bonifácio, Eugénio Pereira, 32469 Petershagen (DE)
(74) Representative: Scheidiger, Michael

(57) **Abstract**

The invention relates to a method for testing a wire harness (100) on a wiring board (1), the wire harness comprising a plurality of wires (10) connected between a plurality of wiring connectors (14), the wiring connectors comprising respectively at least one electric wire terminal (12) associated with at least one of the wires. The method comprises: providing a plurality of test adapters (20, 20a, 20b), comprising a master test adapter (20b) having a power supply (3) and a satellite test adapter (20a), wherein each test adapter comprises at least one testing terminal (22) configured for being electrically connected to the at least one electric wire terminal of the respective wiring connector, connecting a first electric wire terminal of a first wire to the testing terminal of the master test adapter, connecting a second electric wire terminal of the first wire to the testing terminal of the satellite test adapter, powering, through the power supply, the master test adapter, powering, by the master test adapter, the satellite test adapter through the first wire, and testing an electrical connection between the master test adapter and the satellite test adapter through the first wire.

## Description

Wire harnesses are for instance commonly used in automobiles and can transmit electrical energy and/or signals. A wire harness comprises a plurality of wires (cables) which can be connected (assembled) according to a particular assembly map. For proper functioning of the wire harness, each individual connection in the wire harness has to work properly (correctly).

Before the wire harness is installed, e.g., in the automobile, it has to be ensured that the wire harness works properly. This is time consuming and may mean that, in case an error is detected, the wiring harness has to be disassembled.

A method is of interest that can save time and/or can detect an erroneous connection in a wire harness at an early stage.

This problem in solved by the method of claim 1. Advantageous embodiments are given in the dependent claims and/or described below.

The problem is also solved by the kit for in-line testing a wire harness.

A first aspect of the invention relates to a method for testing a wire harness on a wiring board, the wire harness comprising a plurality of wires connected between a plurality of wiring connectors, the wiring connectors comprising respectively at least one electric wire terminal associated with at least one of the wires. The method comprises
- providing a plurality of test adapters, comprising a master test adapter having a power supply and a satellite test adapter, wherein each test adapter comprises at least one testing terminal configured for being electrically connected to the at least one electric wire terminal of the respective wiring connector,
- connecting a first electric wire terminal of a first wire to the testing terminal of the master test adapter,
- connecting a second electric wire terminal of the first wire in the testing terminal of the satellite test adapter,
- powering, through the power supply, the master test adapter,
- powering, by the master test adapter, the satellite test adapter through the first wire, and
- testing an electrical connection between the master test adapter and the satellite test adapter through the first wire.

In an embodiment, the wiring board can comprise or consist of a wire assembly board.

The wire harness (cable harness, wiring harness, cable assembly, wire assembly) can comprise a plurality of wires. The plurality of wires can include a cable, particularly a plurality of cables. The wires of a wire harness can be bound together.

The wires of the wire harness can be connected between a plurality of wiring connectors. Each wire of the wire harness can be associated with at least one electric wire terminal. In an embodiment, each wire of the wire harness is associated with a respective first electric wire terminal and an opposite respective second electric wire terminal. The respective wire can extend between the first electric wire terminal and the second electric wire terminal. The respective wire terminal can be associated with the respective wiring connector. The wiring connectors can comprise at least one electric wire terminal associated with at least one of the wires.

A plurality of test adapters (connectors; testing adapters) can be provided. The plurality of test adapters can comprise a master test adapter (master connector; master testing adapter). The plurality of test adapters can comprise a satellite test adapter (satellite connector; satellite testing adapter). The plurality of test adapters can comprise a plurality of satellite test adapters. The master test adapter can comprise a power supply.

Each test adapter can comprise a processing unit. The master test adapter can comprise a processing unit. The master test adapter can comprise a testing module. The satellite test adapter can comprise a processing unit. The satellite test adapter can comprise a testing module. Each satellite test adapter can comprise a respective processing unit. Each satellite test adapter can comprise a respective testing module. The testing module can comprise the processing unit. The testing module can comprise a test point card.

Each test adapter can comprise at least one testing terminal. The testing terminal can be configured for being electrically connected to the at least one electric wire terminal of the respective wiring connector. The master test adapter can comprise at least one testing terminal. The satellite test adapter can comprise at least one testing terminal. Each satellite test adapter can comprise at least one testing terminal. In an embodiment, the master test adapter and each satellite test adapter can comprise at least one testing terminal.

The first electric wire terminal of a first wire can be connected to the testing terminal of the master test adapter. In an embodiment, a first wiring connector of the first wire can be connected to the testing terminal of the master test adapter.

The (opposite) second electric wire terminal of the first wire can be connected to the testing terminal of the satellite test adapter. In an embodiment, a second wiring connector of the first wire can be connected to the testing terminal of the satellite test adapter.

In an embodiment, a further master test adapter can be provided. In an embodiment, the second wiring connector of the first wire can be connected to the testing terminal of the further master test adapter.

The master test adapter and the satellite test adapter can be connected via the first cable, particularly by inserting the first electric wire terminal of the first wire in the testing terminal of the master test adapter and by inserting the second electric wire terminal of the first wire in the testing terminal of the satellite test adapter.

The master test adapter can be powered by the power supply. The power supply can comprise a battery. The power supply can comprise a rechargeable battery. The power supply can comprise a connection to an external power supply. In an embodiment, the master rest adapter can be powered by the external power supply. In an embodiment, the master rest adapter can be directly powered by the external power supply. In an embodiment, the rechargeable battery of the master test adapter can be charged via the external power supply.

The master test adapter can be configured to emit power towards the satellite test adapter via the first wire. In an embodiment, the master test adapter can power the satellite test adapter through the first wire.

In an embodiment, an electrical connection between the master test adapter and the satellite test adapter through the first wire can be tested. In particular, the electrical connection established between the master test adapter and the satellite test adapter by the first wire can be tested after connection and powering the master test adapter. Advantageously, information with regard to the connecting wire and/or the connection can be derived.

In an embodiment, the connection between the master test adapter and the satellite test adapter can be tested by inspecting whether the powering of the satellite test adapter is successful. A successful powering of the satellite test adapter can indicate that the respective connecting cable (wire) is error-free. A successful powering of the satellite test adapter can indicate that the respective terminals are error-free.

In an embodiment, the connection between the master test adapter and the satellite test adapter can be tested by inspecting whether the powering of the testing terminal of the satellite test adapter is successful. A successful powering of the testing terminal of the satellite test adapter can indicate that the respective connecting cable (wire) is error-free. A successful powering of the testing terminal of the satellite test adapter can indicate that the respective terminals are error-free.

In an embodiment, the connection between the master test adapter and the satellite test adapter can be tested by inspecting whether the powering of the expected testing terminal of the satellite test adapter is successful. A successful powering of the expected testing terminal of the satellite test adapter can indicate that the respective connecting cable (wire) is error-free. A successful powering of the expected testing terminal of the satellite test adapter can indicate that the respective terminals are error-free.

In an embodiment, the expected testing terminal can be the testing terminal intended to power. In an embodiment, the expected testing terminal can be the intended (proper, correct, pre-specified) testing terminal.

In an embodiment, the powering can be used for testing the connection without requiring an additional test signal. An advantage can be that the method can be simplified.

In an embodiment, the method can be configured for in-line testing of the wire harness. In an embodiment, the method can be configured for real time testing of the wire harness. The wire harness, particularly the connections within the wire harness, can be tested during assembly of the wire harness. In an embodiment, after the establishment of each individual connection, the respective connection can be tested by powering the assembled satellite test adapter. In an embodiment, after the establishment of each individual connection, the respective connection can be tested without delay by powering the assembled satellite test adapter. After connection, it can be tested whether the wire is linked to the expected test terminal.

An advantage can be that, if an erroneous connection is detected, this can be immediately detected and corrected. Advantageously, errors can be corrected at an early stage. An advantage can be that it is not necessary to disassemble a complete wire harness, if an erroneous connection is detected in the fully assembled wire harness. Advantageously, time and resources can be saved.

In an embodiment, the powered master test adapter can switch on the power supply to the testing terminal of the master test adapter.

In an embodiment, when the connection exists, power can be transferred from the master test adapter to the satellite test adapter, particularly from the powered master test adapter via the first wire to the testing terminal of the satellite test adapter. In an embodiment, when the proper connection exists, power can be transferred from the master test adapter to the satellite test adapter, particularly from the powered master test adapter via the first wire to the expected testing terminal of the satellite test adapter. In an embodiment, when the connection exists, power can be transferred from the master test adapter to the satellite test adapter, particularly from the powered master test adapter, via the testing terminal, via the first wire, via the second wiring terminal to the testing terminal of the satellite test adapter. In an embodiment, when the connection exists, power can be transferred from the master test adapter to the satellite test adapter, particularly from the powered master test adapter, via the testing terminal, via the connected first wiring terminal, via the first wire, via the second wiring terminal to the testing terminal of the satellite test adapter.

In an embodiment, the satellite test adapter can use the power received from the master test adapter as power supply for itself. In an embodiment, the power received from the master test adapter can be used to power an entity of the satellite test adapter. In an embodiment, the power received from the master test adapter can be used to turn on the electronics in the satellite test adapter. In an embodiment, the received power can be used to power a testing module of the satellite test adapter. In an embodiment, the received power can be used to power a processing unit of the satellite test adapter. In an embodiment, the received power can be used to power a communication unit of the satellite test adapter.

An advantage can be that the power of the master test adapter can be used to activate the satellite test adapter. An advantage can be that the power of the master test adapter can be used to run the satellite test adapter.

In an embodiment, the powering status of the satellite test adapter can indicate whether the connection between the master test adapter and the respective satellite test adapter is established.

In an embodiment, the powering status of a testing terminal of the satellite test adapter can indicate whether the connection between the master test adapter and the respective satellite test adapter is established.

In an embodiment, no own power supply of the satellite testing adapter is required. An advantage can be that the satellite test adapter can be simplified. The production costs can be reduced.

In an embodiment, powering the satellite test adapter by the master test adapter can close an electrical circuit. In an embodiment, the master test adapter and the satellite test adapter can be arranged at a common ground. In an embodiment, the electrical circuit can be closed via the common ground, when power is transmitted from the master test adapter to the satellite test adapter, particularly via the expected testing terminal of the satellite test adapter.

In an embodiment, the testing of the electrical connection includes emitting an electric testing signal from the master test adapter through the first wire, and powering, with the electric testing signal from the master test adapter, the satellite test adapter.

In an embodiment, the testing of the electrical connection includes emitting an electric testing signal from the master test adapter through the first wire, and powering, with the electric testing signal from the master test adapter, the test terminal of the satellite test adapter, particularly the expected test terminal of the satellite test adapter.

In an embodiment, when the connection exists, the electrical testing signal can be transferred from the master test adapter to the satellite test adapter, particularly from the powered master test adapter, via the testing terminal, via the connected first wiring terminal, via the first wire, via the second wiring terminal to the testing terminal of the satellite test adapter. In an embodiment, when the connection exists, the electrical testing signal can be transferred from the master test adapter to the satellite test adapter, particularly from the powered master test adapter via the first wire to the testing terminal of the satellite test adapter. In an embodiment, when the connection exists, the electrical testing signal can be transferred from the master test adapter to the satellite test adapter, particularly from the powered master test adapter, via the testing terminal, via the first wire, via the second wiring terminal to the testing terminal of the satellite test adapter.

In an embodiment, the electrical testing signal emitted by the master test adapter can be configured to power an entity of the satellite test adapter. In an embodiment, the electrical testing signal received from the master can be used to turn on the electronics in satellite test adapter. In an embodiment, the received electrical testing signal can be used to power a processing unit of the satellite test adapter.

An advantage can be that the emitted electrical testing signal of the master test adapter can be used to activate the satellite test adapter. An advantage can be that the testing method can be simplified.

In an embodiment, the method further comprises the step of storing, by the satellite test adapter (satellite connector; satellite testing adapter), the power from the master test adapter (master connector; master testing adapter) provided to the satellite test adapter.

In an embodiment, the storing of the power from the master test adapter can be performed via a battery of the satellite test adapter. In an embodiment, the storing of the power from the master test adapter can be performed via a re-chargeable battery of the satellite test adapter. In an embodiment, the storing of the power from the master test adapter can be performed via a capacitor of the satellite test adapter.

The satellite connector can comprise a rechargeable power source, wherein the method can comprise the step of recharging the rechargeable power source of the satellite connector, when powering the satellite connector with the power from the master connector.

The satellite connector can comprise a capacitor, wherein the method can comprise the step of storing electrical energy by the capacitor of the satellite connector, when powering the satellite connector with the power from the master connector.

In an embodiment, power can be stored by the satellite test adapter previously provided by the master test adapter. An advantage can be that the satellite test adapter can be active after testing its connection with the master test adapter, when the powering is shut off. In an embodiment, the satellite test adapter can indicate that the connection (with the master test adapter) was error-free after the powering via the master test adapter is finished, using the stored power. In an embodiment, the satellite test adapter can provide data to an analysis device and/or an external device, after the powering via the master test adapter is finished, using the stored power.

An advantage can be that the satellite test adapter can output the indication of the connection after finishing the powering via the master test adapter. An advantage can be that the variability of the method can be increased.

In an embodiment, the method further comprises outputting a signal (output signal) from the satellite test adapter using the power from the master test adapter, when the processing unit of the satellite test adapter is powered by the master test adapter and detects the electric testing signal.

In an embodiment, the method further comprises the step of outputting no signal from the satellite test adapter, when the testing module of the satellite test adapter is unpowered, particularly unpowered by the master test adapter.

In an embodiment, the method further comprises the step of outputting no signal from the satellite test adapter, when the processing unit of the satellite test adapter is unpowered, particularly unpowered by the master test adapter.

In an embodiment, the method further comprises the step of outputting no signal from the satellite test adapter, when an unexpected testing terminal of the satellite test adapter is powered, particularly powered by the master test adapter.

In an embodiment, the method further comprises the step of outputting no signal from the satellite test adapter, when the processing unit of the satellite test adapter detects an erroneous signal. In an embodiment, the method further comprises the step of outputting no signal from the satellite test adapter, when the testing module of the satellite test adapter detects an erroneous signal. The erroneous signal can comprise an indication that the unexpected testing terminal is powered. The erroneous signal can comprise an indication that the connection is established via the unexpected testing terminal.

In an embodiment, the method further comprises outputting a signal from the satellite test adapter using the power from the master test adapter, when the processing unit of the satellite test adapter is powered by the master test adapter and detects the electric testing signal, and outputting no signal from the satellite test adapter, when the processing unit of the satellite test connector is unpowered, particularly unpowered by the master test connector.

In an embodiment, the method further comprises outputting a signal from the satellite test adapter using the power from the master test adapter, when the processing unit of the satellite test adapter is powered by the master test adapter and detects the electric testing signal, and outputting no signal from the satellite test adapter, when the processing unit of the satellite test adapter detects an erroneous signal.

The processing unit of the satellite test adapter can be configured to be powered via the master test adapter. The processing unit of the satellite test adapter can be configured to detect the electric testing signal received from the master test adapter. The processing unit of the satellite test adapter can be configured to analyse the electric testing signal received from the master test adapter.

The testing module of the satellite test adapter can be configured to be powered via the master test adapter. The testing module of the satellite test adapter can be configured to detect the electric testing signal received from the master test adapter. The testing module of the satellite test adapter can be configured to analyse the electric testing signal received from the master test adapter.

In an embodiment, powering the satellite test adapter can initiate outputting the output signal. In an embodiment, powering the processing unit of the satellite test adapter can initiate outputting the output signal.

In an embodiment, detecting the electric testing signal can comprise recognising on which testing terminal the power supplied by the master test adapter arrived. In an embodiment, detecting the electric testing signal can comprise recognising whether the power supplied by the master test adapter arrived at the expected testing terminal. In an embodiment, the satellite test adapter can be configured to determine whether the power supplied by the master test adapter arrived at the expected testing terminal. In an embodiment, the satellite test adapter can be configured to determine whether the power supplied by the master test adapter arrived at the unexpected testing terminal. In an embodiment, detecting the electric testing signal can comprise determining the powering of the satellite test adapter. In an embodiment, detecting the electric testing signal can comprise determining the powering of the processing unit of the satellite test adapter.

In an embodiment, the satellite test adapter can recognise on which testing terminal the power supplied by the master test adapter arrived. In an embodiment, the satellite test adapter can determine on which testing terminal the power supplied by the master test adapter arrived.

In an embodiment, outputting the signal can comprise sending an information wirelessly to a wireless hub. The wireless hub can forward the information to a test programme. In an embodiment, outputting the signal can comprise sending an information via a wire to a communication hub. The communication hub can forward the information to the test programme. In an embodiment, outputting the signal can comprise outputting an optical (visual) signal. In an embodiment, outputting the signal can comprise outputting an acoustic signal.

In an embodiment, the powering status of the satellite test adapter can indicate whether the connection between the master test adapter and the respective satellite test adapter is established. An advantage can be that establishing of the connection can be displayed in a simple manner.

The erroneous signal can be a detected when power is supplied from the master test adapter to an unexpected testing terminal of the satellite test adapter.

An advantage can be that the power used for testing can also be used to indicate whether the connection is established or not. An advantage can be that no additional energy is required to indicate the establishment of the connection.

In an embodiment, the method further comprises outputting a signal (output signal) from the satellite test adapter using the stored power.

In an embodiment, the method further comprises outputting a signal (output signal) from the satellite test adapter using the power stored in the re-chargeable battery. In an embodiment, the method further comprises outputting a signal (output signal) from the satellite test adapter using the stored in the capacitor.

In an embodiment, the method further comprises outputting a signal from the satellite test adapter using the stored power, when the processing unit of the satellite test adapter detects the provided electric testing signal. In an embodiment, the method further comprises outputting a signal from the satellite test adapter using the stored power, when the processing unit of the satellite test adapter detects the previously provided electric testing signal.

In an embodiment, the method further comprises delayed outputting the output signal from the satellite test adapter using the stored power.

In an embodiment, the method can comprise emitting power by the master test adapter to the satellite test adapter, storing the provided electrical power by the satellite test adapter, when the power is received by the satellite test adapter, and outputting the output signal using the stored power. The signal can be output after finishing the powering of the satellite test adapter by the master test adapter.

In an embodiment, the method can comprise emitting the test signal by the master test adapter to the satellite test adapter, storing the provided electrical power by the satellite test adapter, when the power is received by the satellite test adapter, detecting that the test signal is error-free, and outputting the output signal using the stored power. The output signal can be output after finishing providing the electric testing signal to the satellite test adapter.

In an embodiment, the powering status of the satellite test adapter can indicate whether the connection between the master test adapter and the respective satellite test adapter is established. In an embodiment, the powering status of the satellite test adapter can indicate whether the connection between the master test adapter and the expected testing terminal of the respective satellite test adapter is established.

The powering status can relate to the charging status of the rechargeable battery of the satellite test adapter. The powering status can relate to the charging status of the capacitor of the satellite test adapter.

In an embodiment, the method further comprises outputting no signal from the satellite test adapter, when the processing unit of the satellite test adapter detects an erroneous electric testing signal received from the master test adapter.

In an embodiment, the method further comprises outputting a signal from the satellite test adapter using the stored power, particularly when the processing unit of the satellite test adapter detects the provided electric testing signal, and outputting no signal from the satellite test adapter, when the processing unit of the satellite test adapter detects an erroneous electric testing signal received from the master test adapter.

An advantage can be that the user can easily recognise the erroneous connection and/or the erroneous wire.

In an embodiment, the method further comprises outputting a signal from the satellite test adapter using the stored power, when a charging level is reached.

The charging level can relate to the charging of the rechargeable battery of the satellite test adapter. The charging level can relate to the charging of the capacitor of the satellite test adapter.

In an embodiment, the method further comprises outputting no signal from the satellite test adapter, when the stored power is below a pre-determined threshold value.

In an embodiment, the method further comprises outputting a signal from the satellite test adapter using the stored power, when a charging level is reached, and outputting no signal from the satellite test adapter, when the stored power is below a pre-determined threshold value.

In an embodiment, the method further comprises analysing, with an analysis device, the signal output from the satellite test adapter using the power provided by the master test adapter.

In an embodiment, the method further comprises analysing, with an analysis device, the signal output from the satellite test adapter using the power provided by the master test adapter, particularly the power from the electric testing signal.

In an embodiment, wherein the method further comprises analysing, with an analysis device, the signal output from the satellite test adapter using the stored power previously provided by the master test adapter.

In an embodiment, wherein the method further comprises analysing, with an analysis device, the signal output from the satellite test adapter using the power provided by the master test adapter, particularly the power from the electric testing signal, and the stored power previously provided by the master test adapter.

An advantage can be that the signal output can be further analysed. Advantageously, this can provide additional information about the connection, e.g. the quality of the connection.

In an embodiment, the testing module can comprise the analysis device. In an embodiment, the communication module can be configured to communicate with the analysis device.

In an embodiment, the method further comprises connecting a plurality of satellite test adapters with the master test adapter, and powering, with the master test adapter, each satellite test adapter of the plurality of satellite test adapters.

In an embodiment, the method further comprises connecting a plurality of satellite test adapters with the master test adapter, emitting electric testing signals from the master test adapter through connecting wires, and powering, with the respective electric testing signals from the master test adapter, each satellite test adapter of the plurality of satellite test adapters.

In an embodiment, the method further comprises connecting a plurality of satellite test adapters with the master test adapter, emitting electric testing signals from the master test adapter through connecting wires, and powering, with the respective electric testing signals from the master test adapter, a respective testing terminal of each satellite test adapter of the plurality of satellite test adapters, particularly the respective expected testing terminal.

In an embodiment, the method further comprises connecting a first satellite test adapter with the master test adapter, connecting a second satellite test adapter with the master test adapter, emitting a first electric testing signal from the master test adapter through the connecting wire, and powering, with the first electric testing signal from the master test adapter, the first satellite test adapter, and emitting a second electric testing signal from the master test adapter through the connecting wire, and powering, with the second electric testing signal from the master test adapter, the second satellite test adapter.

In an embodiment, the method further comprises connecting a first satellite test adapter with the master test adapter, connecting a second satellite test adapter with the master test adapter, emitting a first electric testing signal from the master test adapter through the connecting wire, and powering, with the first electric testing signal from the master test adapter, the testing terminal of the first satellite test adapter, and emitting a second electric testing signal from the master test adapter through the connecting wire, and powering, with the second electric testing signal from the master test adapter, the testing terminal of the second satellite test adapter.

The first electric testing signal can differ from the second electric testing signal. The first electric testing signal and the second electric testing signal can be equal. The first electric testing signal and the second electric testing signal can be emitted in a sequence. The first electric testing signal and the second electric testing signal can be emitted simultaneously.

An advantage can be that a plurality of connections can be tested. The respective testing can be tailored with regard to the particular connection and/or the particular wire and/or the particular testing terminal.

In an embodiment, the method further comprises connecting a plurality of satellite test adapters with the master test adapter in an assembly order, and powering, with the master test adapter, each satellite test adapter of the plurality of satellite test adapters in the assembly order.

In an embodiment, the method further comprises connecting a first satellite test adapter with the master test adapter, emitting a first electric testing signal from the master test adapter through the connecting wire, and powering, with the first electric testing signal from the master test adapter, the first satellite test adapter, and afterwards connecting a second satellite test adapter with the master test adapter, emitting a second electric testing signal from the master test adapter through the connecting wire, and powering, with the second electric testing signal from the master test adapter, the second satellite test adapter.

In an embodiment, the method further comprises connecting a first satellite test adapter with the master test adapter and afterwards connecting a second satellite test adapter with the master test adapter, emitting a first electric testing signal from the master test adapter through the connecting wire, and powering, with the first electric testing signal from the master test adapter, the first satellite test adapter, and afterwards emitting a second electric testing signal from the master test adapter through the connecting wire, and powering, with the second electric testing signal from the master test adapter, the second satellite test adapter.

An advantage can be that a plurality of connections and/or wires and/or testing terminals can be tested in a sequential manner.

The first electric testing signal can differ from the second electric testing signal. The first electric testing signal and the second electric testing signal can be equal.

An advantage can be that a plurality of connections can be tested. The respective electrical testing signal can be tailored with regard to the particular connection and/or the particular wire and/or the particular testing terminal. The respective electrical testing signal can be selected accordingly.

In an embodiment, the method further comprises the steps of
- providing a common ground,
- arranging the plurality of test adapters electrically connectable to the common ground, and
- closing an electrical circuit via the common ground, the master test adapter and the satellite test adapter, when powering the satellite test adapter by the master test adapter.

In an embodiment, the method further comprises the steps of
- providing a common ground,
- arranging the plurality of test adapters electrically connectable to the common ground, and
- closing an electrical circuit via the common ground, the master test adapter and the satellite test adapter, when powering the testing terminal of the satellite test adapter (particularly the expected testing terminal) by the master test adapter.

In an embodiment, the method further comprises the steps of
- providing a common ground,
- arranging the plurality of test adapters electrically connectable to the common ground, and
- closing an electrical circuit via the common ground, the master test adapter and the satellite test adapter, when emitting the electric testing signal from the master test adapter to the satellite test adapter.

In an embodiment, the method further comprises the steps of
- providing a common ground,
- arranging the plurality of test adapters electrically connectable to the common ground, and
- closing an electrical circuit via the common ground, the master test adapter and the satellite test adapter, when powering the satellite test adapter by the master test adapter and emitting the electric testing signal from the master test adapter to the satellite test adapter.

In an embodiment, the method further comprises the steps of
- providing a common ground,
- arranging the master test adapter and the at least one satellite test adapter electrically connectable to the common ground, and
- closing the electrical circuit via the common ground, the master test adapter and the at least one satellite test adapter, when powering the satellite test adapter by the master test adapter and emitting the electric testing signal from the master test adapter to the at least one satellite test adapter.

The common ground can comprise the electrical ground path. The common ground can consist of the electrical ground path. The common ground can be the electrical ground path. The common ground can comprise or consist of a metallic plate. The common ground can comprise or consist of a metallic grid.

The assembly board can comprise the common ground. The common ground can be provided by the assembly board. The assembly board can be configured for closing the electrical circuit.

In an embodiment, testing the electrical connection can be established by closing the electrical circuit. In an embodiment, the output signal can be output, when the electrical circuit via the common ground is closed.

In an embodiment, the method further comprises selecting the electric testing signal from a constant voltage, a non-constant voltage, a transient voltage, a periodic voltage, a switching on and off of a pre-selected voltage, a switching on of a pre-selected voltage for a pre-determined duration and a switching of after the pre-determined duration, and powering the satellite test adapter from the master test adapter with the selected electrical testing signal.

The respective electrical testing signal can be tailored with regard to the particular connection and/or the particular wire and/or the particular testing terminal. The respective electrical testing signal can be selected accordingly.

For each connection, an individual electrical testing signal can be selected. In an embodiment, each connection can be tested with a respective individually selected electric testing signal. For each wire, an individual electrical testing signal can be selected. In an embodiment, each wire can be tested with a respective individually selected electric testing signal. For each testing terminal, an individual electrical testing signal can be selected. In an embodiment, each testing terminal can be tested with a respective individually selected electric testing signal.

In an embodiment, a common electrical testing signal can be selected wherein each connection can be tested with the same common electrical testing signal. In an embodiment, each connection can be tested with the same selected electric testing signal. In an embodiment, a common electrical testing signal can be selected wherein each wire can be tested with the same common electrical testing signal. In an embodiment, each wire can be tested with the same selected electric testing signal. In an embodiment, a common electrical testing signal can be selected wherein each testing terminal can be tested with the same common electrical testing signal. In an embodiment, each testing terminal can be tested with the same selected electric testing signal.

The electrical testing signal can be constant in time. In an embodiment, the electrical testing signal can vary in a time-dependent manner. The electrical testing signal can periodically change.

The electrical testing signal can be tailored for testing the respective connection and/or wire and/or testing terminal.

An advantage can be that multiple connections with different requirements can be tested. An advantage can be that multiple satellite test adapters with different requirements can be powered.

In an embodiment, the method further comprises connecting a plurality of satellite test adapters with the master test adapter, and powering each satellite test adapter of the plurality of satellite adapters with a respective previously selected electrical test signal.

In an embodiment, each satellite test adapter can be powered by an individual selected electric testing signal.

The first satellite test adapter can be powered by a first selected electrical testing signal. The second satellite test adapter can be powered by a second selected electrical testing signal. The first selected electrical testing signal can differ from the second selected electrical testing signal. The first selected electrical testing signal and the second selected electrical testing signal can be identical.

The respective electrical testing signal can be selected depending on the respective satellite test adapter to power with the respective electrical testing signal. The respective electrical testing signal can be tailored for the respective satellite test adapter to power with the respective electrical testing signal.

The respective electrical testing signal can be selected depending on the respective connection. The respective electrical testing signal can be selected depending on the respective wire.

An advantage can be that multiple connections with different requirements can be tested. An advantage can be that multiple satellite test adapters with different requirements can be powered.

In an embodiment, a sequence of electrical testing signals corresponding to the order of satellite test adapter can be pre-defined. The plurality of satellite test adapters can be powered in the order of assembly with the corresponding sequence of electrical testing signals. The sequence of electrical testing signals can comprise or consist of a plurality of identical electrical testing signals. The sequence of electrical testing signals can comprise or consist of a plurality of different electrical testing signals.

In an embodiment, the method further comprises connecting a plurality of satellite test adapters with the master test adapter, and powering at least one testing terminal of each satellite test adapter of the plurality of satellite adapters with a respective previously selected electrical test signal.

In an embodiment, the wiring connectors comprise respectively a plurality of electric wire terminal, each associated with a corresponding one of the wires, the method comprises
- connecting respective electric wire terminals of the wires to respective testing terminals of the master test adapter,
- connecting respective electric wire terminals of the wires to respective testing terminals of the satellite test adapter,
- powering, through the power supply, the master test adapter,
- powering, by the master test adapter, the satellite test adapter through at least one of the wires, and
- testing respective electrical connections between the master test adapter and the satellite test adapter through the wires.

In an embodiment, the wiring connectors comprise respectively a plurality of electric wire terminal, each associated with a corresponding one of the wires, the method comprises
- connecting respective electric wire terminals of the wires to respective testing terminals of the master test adapter,
- connecting respective electric wire terminals of the wires to respective testing terminals of the satellite test adapter,
- powering, through the power supply, the master test adapter,
- powering, by the master test adapter, the testing terminal of the satellite test adapter through at least one of the wires, and
- testing respective electrical connections between the master test adapter and the satellite test adapter through the wires.

An advantage can be that a plurality of connections can be tested.

In an embodiment, prior to powering, by the master connector, the satellite connector through the first wire, the method further comprises receiving, by the master test adapter, a command sent by a processing unit, the command comprising information relating to the powering and/or the electrical test signal.

The command can comprise information satellite test adapter to power. The command can comprise information which testing terminal in which satellite test adapter to power. The command can comprise information about the satellite test adapter to test. The command can comprise information which satellite test adapter to power with which electrical test signal. The command can comprise information which testing terminal of satellite test adapter to power with which electrical test signal. The command can comprise the order of assembly. The command can comprise the sequence of electrical test signals.

In an embodiment, prior to powering, by the master connector, the satellite connector through the first wire, the method further comprises receiving, by the master test adapter, a command sent by a processing unit, the command comprising information which satellite test adapter to power. In an embodiment, prior to powering, by the master connector, the satellite connector through the first wire, the method further comprises receiving, by the master test adapter, a command sent by a processing unit, the command comprising information which testing terminal in which satellite test adapter to power.

The method can comprise the step of receiving, by the processing unit, a feedback signal from the powered satellite test adapter. The method can comprise the step of receiving, by the processing unit, a feedback signal from the powered testing terminal of the satellite test adapter.

In an embodiment, the processing unit can be configured to receive a feedback signal from the satellite test adapter. In an embodiment, the processing unit can be configured to receive the output signal from the satellite test adapter. The processing unit can be configured to analyse the received feedback signal. The processing unit can be configured to compare the received feedback signal with the electrical test signal. The processing unit can be configured to determine a match between the received feedback signal and the electrical test signal. The processing unit can be configured to verify whether a match between the received feedback signal and the electrical test signal exists.

In an embodiment, the analysis device can be configured to receive the feedback signal from the satellite test adapter. The analysis device can be configured to analyse the received feedback signal. The analysis device can be configured to compare the received feedback signal with the electrical test signal. The analysis device can be configured to determine a match between the received feedback signal and the electrical test signal. The analysis device can be configured to verify whether a match between the received feedback signal and the electrical test signal exists.

An advantage can be that the testing can be improved.

In an embodiment, the method further comprises the steps of
- charging the power source of the satellite test adapter by the master test adapter,
- connecting a first electric wire terminal of a further wire to the testing terminal of the satellite test connector charged by the master test adapter,
- connecting a second electric wire terminal of the further wire in the testing terminal of a further satellite test adapter,
- powering, through the charged power supply of the satellite test adapter, the satellite test adapter,
- powering, by the powered satellite test adapter, the further satellite test adapter through the further wire, and
- testing an electrical connection between the powered satellite test adapter and the further satellite test adapter through the further wire.

The power provided by the master test adapter can be used to charge the satellite test adapter. The charged satellite test adapter can be configured to power the further connected satellite test adapter. The charged satellite test adapter can take over the function of the master test adapter to power the further connected satellite test adapter. The charged satellite test adapter can provide the electrical test signal to the further satellite test adapter.

An advantage can be that a branched wire harness can be tested by the method without requiring a further master test adapter. The applicability of the method can advantageously be increased.

The master test adapter can transiently charge the satellite test adapter which can then power the further satellite test adapter.

A further aspect of the invention relates to a kit of test adapters configured for performing the method according to the invention. The kit of test adapters can comprise a master test adapter and at least one satellite test connector.

A further aspect of the invention relates to a system comprising a plurality of test adapters configured for performing the method according to the invention and a common ground. The system can comprise one master test adapter, at least one satellite test connector and an assembly board. The system can comprise one master test adapter, a plurality of satellite test connectors and the assembly board. Each test adapter of the plurality of test adapters can be arrangeable at the assembly board.

Further features and embodiments of the present invention are described in the following with reference to the Figures, wherein:
- Fig. 1: shows a schematic illustration of a wire harness,
- Fig. 2: shows a schematic illustration of an embodiment of a test adapter,
- Fig. 3: shows a schematic illustration of an assembly board,
- Fig. 4: shows a schematic flow chart of an embodiment of the method, and
- Fig. 5: shows a schematic flow chart of a further embodiment of the method.

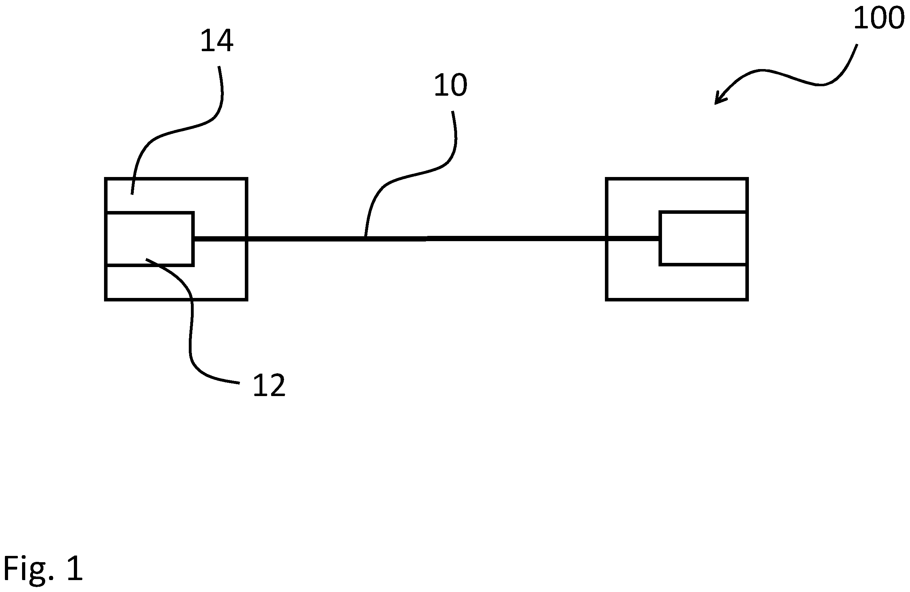

Figure 1 shows a schematic illustration of a wire harness 100. The wire harness 100 can comprise a wire 10. The wire harness 100 can comprise a plurality of wires 10. The wire harness 100 can comprise a wiring connector 14. The wire harness 100 can comprise a plurality of wiring connectors 14. The wiring connector 14 can comprise a wire terminal 12. Each wiring connector 14 can comprise at least one wire terminal 12. Each wiring connector 14 can comprise a plurality of wire terminals 12. The wire terminal 12 can be associated with the respective wire 10. Each wire terminal 12 can be associated with a respective wire 10. The wire 10 can connect a first wiring connector 14 and a second wiring connector 14.

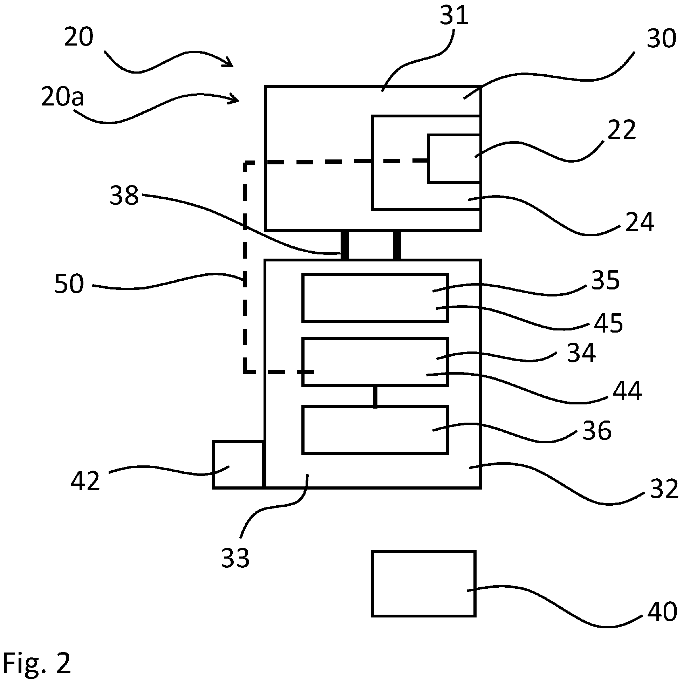

In Figure 2, an illustration of an exemplary embodiment of a test adapter 20 is provided. As an example, an embodiment of a satellite test adapter 20a is illustrated.

The test adapter 20, 20a can be configured to perform the method according to the invention. The test adapter 20 can be a part of the kit of test adapters 20. The illustrated exemplary test adapter 20 can be part of the system configured for performing the method according to the invention.

The test adapter 20, 20a can comprise a base unit 32. The test adapter 20, 20a can comprise a socket unit 30. The socket unit 30 can be attached to the base unit 32. The socket unit 30 can be connected to the base unit 32. The socket unit 30 can be attached to the base unit 32 via a mechanical connector assembly 38. In an embodiment, the socket unit 30 can be reversibly and repeatedly attached to the base unit 32 via the mechanical connector assembly 38. The socket unit 30 can comprise a housing 31. The base unit 32 can comprise a housing 33.

The socket unit 30 can comprise a testing connector 24. The socket unit 30 can comprise a testing terminal 22. The socket unit 30 can comprise a plurality of testing terminals 22. The testing connector 24 can comprise a plurality of testing terminals 22.

The base unit 32 can comprise at least one testing module 24. At least one testing module 34 can be arranged in the base unit 32. The base unit 32 can comprise the testing module 34 and a further testing module 35. The testing module 34 can comprise a processing unit 44. Each testing module 34, 35 can comprise at least one respective processing unit 44, 45. The testing module 34 and/or the further testing module 35 can comprise a test point card.

The base unit 32 can comprise a communication module 36. The communication module 36 can configured for wireless communication with a wireless communication hub 40. The communication module 36 can be communicatively connected with the wireless communication hub 40. The communication module 36 can comprise a wireless card.

The base unit 32 can comprise an attachment unit 42. The attachment unit 42 can be configured for attaching the base unit 32 to the wiring board.

The housing 33 of the base unit 32 can be configured for housing the testing module 34 and the communication module 36. The housing 31 of the socket unit 30 can be configured for housing the testing connector 24.

The testing module 34 can be configured to detect the testing signal 50 received at the testing terminal 22 (and/or received at the testing connector 24). The testing module 34 can be configured for analysing the testing signal 50.

In an embodiment, the testing signal 50 can power the testing module 34. When powered, the testing module 34 can activate the communication module 36 to output a feedback signal.

The processing module 44 can be configured to detect the testing signal 50 received at the testing terminal 22 (and/or received at the testing connector 24). The processing module 44 can be configured for analysing the testing signal 50.

In an embodiment, the testing signal 50 can power the processing module 44. When powered, the processing module 44 can activate the communication module 36 to output a feedback signal.

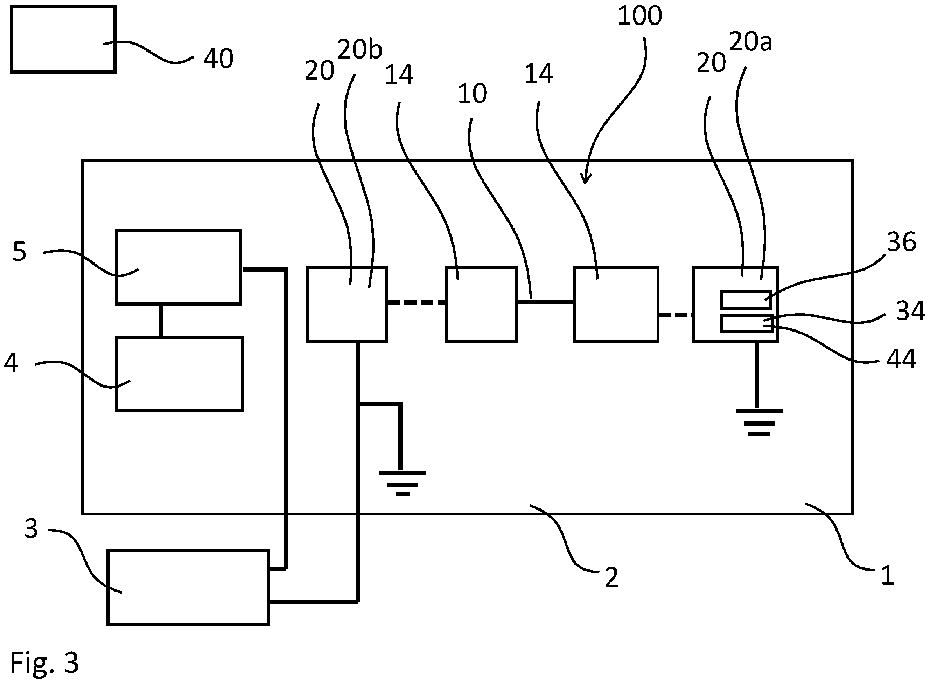

In Figure 3, an embodiment of an assembly board 1 (wiring board 1) is illustrated. The assembly board 1 can comprise a metal plate 2. The assembly board 1 can comprise a metal grid. The assembly board 1 can provide the common ground.

In the illustrated example, a plurality of test adapters 20, 20a, 20b can be arranged at the wiring board 1. The plurality of test adapters 20, 20a, 20b can comprise one master test adapter 20b. The plurality of test adapters 20, 20a, 20b can comprise one satellite test adapter 20a. The plurality of test adapters 20, 20a, 20b can comprise one master test adapter 20b and one satellite test adapter 20a.

The satellite test adapter 20a can be grounded at the wiring board 1. In the illustrated example, the satellite test adapter 20a is not directly connected with a power source. In particular, in the illustrated example, the satellite test adapter 20a is not directly powered by a respective power source.

The master test adapter 20b can be connected with a power source 3 (power supply 3). The master test adapter 20b can be powered by the power source 3. The master test adapter 20b can directly be powered by the power source 3.

The power source 3 can also provide power to a communication hub 5. The power source 3 can also power a human-machine-interface (HMI) 4. The HMI 4 can be operatively coupled with the communication hub 5. The communication hub 5 can be configured for wireless communication. In an embodiment, the communication hub 5 can be configured for wired communication, for instance with the wireless communication hub 40.

In the illustrated example one wiring connector 14 of the wiring harness 100 can be connected with the master test adapter 20b. In the illustrated example one wiring connector 14 of the wiring harness 100 can be connected with the satellite test adapter 20a. The wiring connectors 14 are connected via the wire 10.

When the master test adapter 20b is powered by the power source 3, power can be transmitted from the power source 3 via the master test adapter 20b and via the wire 10 of the wire harness 100 to the satellite test adapter 20a. The transmitted power can power the satellite test adapter 20a. The transmitted power can power the testing terminal 22 of the satellite test adapter 20a. The power provided to the master test adapter 20b by the power source 3 can be used to indirectly power the satellite test adapter 20a. In an embodiment, the power transmitted via the wire 10 from the master test adapter 20b to the satellite test adapter 20a can power the testing module 34 (and/or the processing module 44) of the satellite test adapter 20a. In an embodiment, the communication module 36 of the satellite test adapter 20a can output an output signal, when the satellite test adapter 20a is powered via the master test adapter 20b. The output signal can be a visual signal. The output signal can be an acoustic signal. In an embodiment, the communication module 36 is configured for wireless communication with the wireless communication hub 40 and can send information, e.g. the powering status, to the wireless communication hub 40.

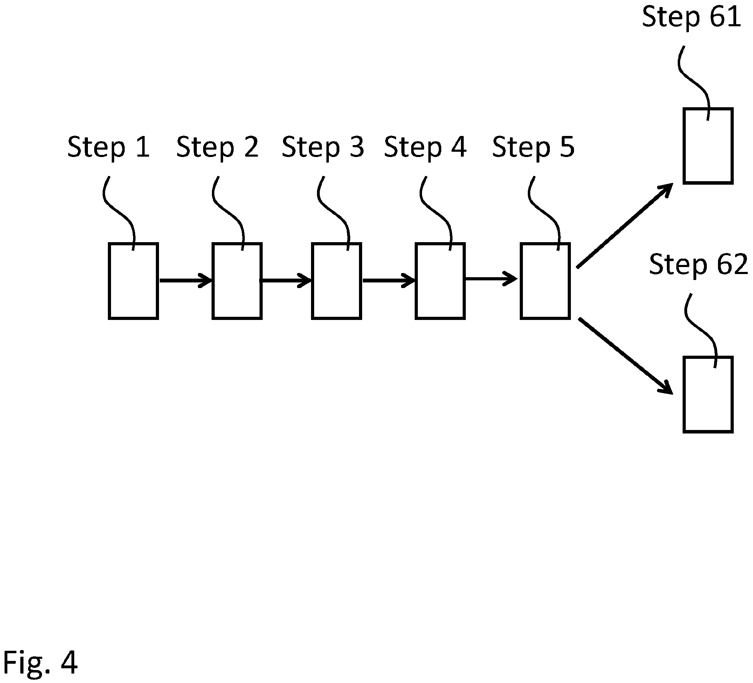

In Figure 4, a schematic flowchart of an embodiment of the invention is shown.

The master test adapter and the satellite test adapter can be provided. The master test adapter and the satellite test adapter can be arranged on the wiring board (step 1), particularly on the common ground. The wire harness can be provided. The wire harness can comprise the wire and wiring connectors with wire terminals. The wire harness can be connected with the master test adapter and the satellite test adapter. In particular, the first electric wire terminal can be connected with the master test adapter and the second electric wire terminal can be connected with the testing terminal of the satellite test adapter (step 2). The master test adapter can be powered (step 3). The master test adapter can be powered by an external power supply. The master test adapter can comprise an internal power supply configured to power the master test adapter. The internal power supply can be re-chargeable. The powered master test adapter can power the satellite test adapter (step 4). The electrical connection between the master test adapter and the satellite test adapter can be tested (step 5). When an appropriate electrical connection can be detected, for instance when the satellite test adapter is powered, the satellite test adapter can output a signal output, e.g. output an approval signal (step 61). When an appropriate electrical connection can be detected, for instance when the expected testing terminal of the satellite test adapter is powered, the satellite test adapter can output a signal output, e.g. output an approval signal (step 61). When an erroneous electrical connection can be detected, for instance when the satellite test adapter is unpowered, no signal output (e.g. no approval signal) can be sent by the satellite test adapter (step 62). When an erroneous electrical connection can be detected, for instance when the unexpected testing terminal of the satellite test adapter is powered, no signal output (e.g. no approval signal) can be sent by the satellite test adapter (step 62). When the appropriate electrical connection can be detected, a further wire can be connected and tested considering the respective steps of the method. When an erroneous electrical connection can be detected, the particular connection can be examined and, for instance, the respective wire can be replaced.

In an embodiment, testing of the electrical connection can include emitting the electric testing signal from the master test adapter through the wire. The electric testing signal from the master test adapter can power the satellite test adapter. The electric testing signal from the master test adapter can power the testing terminal of the satellite test adapter.

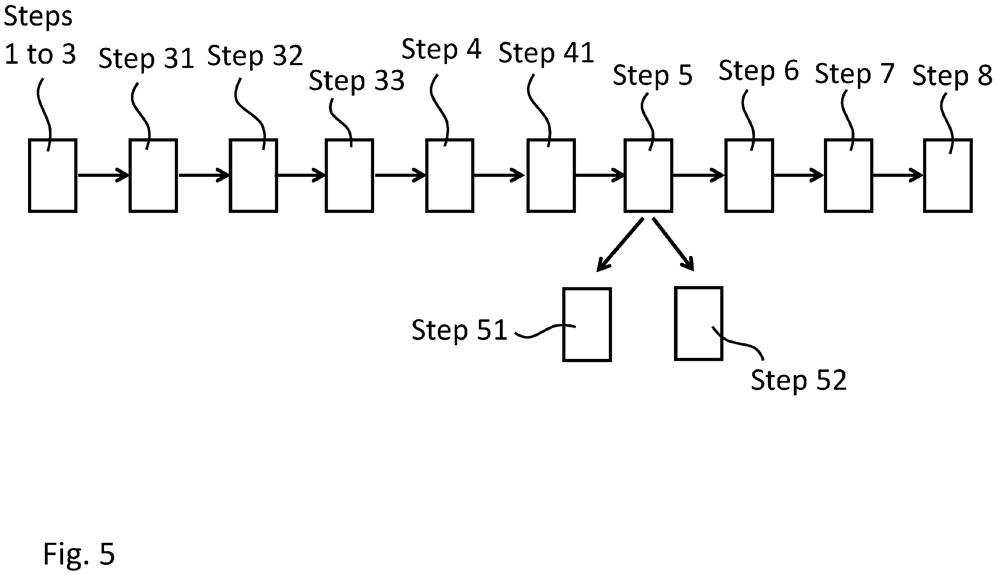

In an embodiment, the method can comprise the following steps (the respective schematic flow chart is given in Figure 5):

The master test adapter and the satellite test adapter can be provided. The master test adapter and the satellite test adapter can be arranged on the wiring board (step 1). The wire harness can comprise the wire and wiring connectors with wire terminals. The wire harness can be connected with the master test adapter and the satellite test adapter. In particular, the first electric wire terminal can be connected with the master test adapter and the second electric wire terminal can be connected with the testing terminal of the satellite test adapter (step 2). The master test adapter can be powered (step 3).

A test programme (for instance running on Raspberry Pi) can provide the next connection (next wire) to test (step 31). The programme can send a respective command to the master test adapter (step 32). The master test adapter can switch power to the corresponding test terminal (step 33). When a connection exists, the power (e.g. a testing signal) can be transferred to the satellite test adapter. When a connection exists, the powered master test adapter can power the connected satellite test adapter (step 4). This can comprise the following steps: power can be transferred from the powered master test adapter through the respective wire to the satellite test adapter. This can particularly comprise the following steps: power can be transferred from the powered master test adapter via its testing terminal to the connected wire terminal through the respective wire to the wiring terminal and the respective testing terminal of the satellite test adapter.

The satellite test adapter can use the transferred power (transferred from the master test adapter) as power supply for itself. The satellite test adapter can be powered (step 4). In an embodiment, electronics of the satellite test adapter can turn on (step 41). In an embodiment, the testing module of the satellite test adapter can be powered. In an embodiment, the communication module of the satellite test adapter can be powered.

The electrical connection between the master test adapter and the satellite test adapter can be tested (step 5). In an embodiment, the satellite test adapter can recognise on which testing terminal the power provided by the master test adapter arrived (step 51). In an embodiment, the satellite test adapter can analyse the power and/or the testing signal provided by the master test adapter (step 52). In an embodiment, the satellite test adapter can recognise on which testing terminal the power provided by the master test adapter arrived (step 51) and can analyse the power and/or the testing signal provided by the master test adapter (step 52).

The satellite test adapter can send this information (e.g. on which testing terminal the power provided by the master test adapter arrived) wireless to a wireless communication hub (step 6). The satellite test adapter can send this information (e.g. on which testing terminal the power provided by the master test adapter arrived) wired to a communication hub. When an appropriate electrical connection can be detected, for instance when the satellite test adapter is powered, the satellite test adapter can output a signal output, e.g. output an approval signal (step 61). When an appropriate electrical connection can be detected, for instance when the expected testing terminal of the satellite test adapter is powered, the satellite test adapter can output a signal output, e.g. output an approval signal (step 61).

In an embodiment, wireless communication hub and/or the communication hub can forward the information sent by the satellite test adapter to the test programme (step 7). The programme can evaluate whether the detected powered testing terminal is the expected connection. The programme can evaluate whether the detected powered testing terminal is the unexpected connection (so called short). The programme can evaluate whether a connection is missing. The information can be output on the HMI. The information can be shown to a user, for instance via the HMI (step 8). The steps can be repeated until all testing terminals are checked.

In an embodiment, if an erroneous connection is detected in step 5, 51, 52 by not powering the satellite test adapter, no signal can be output from the satellite test adapter. The programme can be configured to recognise the missing signal. The programme can be configured to display to the user the missing signal. The relating connection can immediately (in particular in real time during assembly) be identified and fixed.

In an embodiment, if an erroneous connection is detected in step 5, 51, 52 by detecting a connection to an erroneous testing terminal, no signal can be output from the satellite test adapter or a failure signal can be transmitted. The programme can be configured to recognise the missing signal. The programme can be configured to recognise the failure signal. The programme can be configured to display to the user the missing signal. The programme can be configured to display to the user the failure signal. The relating connection can immediately (in particular in real time during assembly) be identified and fixed.

An advantage can be that the user can have an immediate feedback, whether the connection is appropriate. An advantage can be that the user can have an immediate feedback, whether the connection is erroneous. If an erroneous connection is detected, the user can immediately take steps to correct the error, e.g. replace the respective wire. An advantage can be that erroneous connections can be detected at an early stage. The assembly process of the wire harness can advantageously be improved. An advantage can be that waste can be reduced. Advantageously, resources can be saved.

## Claims

1. A method for testing a wire harness (100) on a wiring board (1),
the wire harness comprising a plurality of wires (10) connected between a plurality of wiring connectors (14), the wiring connectors comprising respectively at least one electric wire terminal (12) associated with at least one of the wires,
the method comprising:
- providing a plurality of test adapters (20, 20a, 20b), comprising a master test adapter (20b) having a power supply (3) and a satellite test adapter (20a), wherein each test adapter comprises at least one testing terminal (22) configured for being electrically connected to the at least one electric wire terminal of the respective wiring connector,
- connecting a first electric wire terminal (12) of a first wire to the testing terminal of the master test adapter,
- connecting a second electric wire terminal (12) of the first wire to the testing terminal of the satellite test adapter,
- powering, through the power supply, the master test adapter,
- powering, by the master test adapter, the satellite test adapter through the first wire, and
- testing an electrical connection between the master test adapter and the satellite test adapter through the first wire.

2. The method of claim 1, wherein the testing of the electrical connection includes emitting an electric testing signal from the master test adapter through the first wire, and powering, with the electric testing signal from the master test adapter, the satellite test adapter.

3. The method of claim 1 or 2, wherein the method further comprises
- storing, by the satellite test adapter, the power from the master test adapter provided to the satellite test adapter.

4. The method of one of claims 1 to 3, wherein the method further comprises
- outputting a signal from the satellite test adapter using the power from the master test adapter, when a processing unit of the satellite test adapter is powered by the master test adapter and detects the electric testing signal,
and/or
- outputting no signal from the satellite test adapter, when the processing unit of the satellite test adapter is unpowered.

5. The method of one of claims 1 to 4, wherein the method further comprises
- outputting a signal from the satellite test adapter using the stored power, particularly when the processing unit of the satellite test adapter detects the provided electric testing signal, and/or
- outputting no signal from the satellite test adapter, when the processing unit of the satellite test adapter detects an erroneous electric testing signal received from the master test adapter.

6. The method of one of claims 1 to 5, wherein the method further comprises
- outputting a signal from the satellite test adapter using the stored power, when a charging level is reached, and/or
- outputting no signal from the satellite test adapter, when the stored power is below a pre-determined threshold value.

7. The method of one of claims 1 to 6, wherein the method further comprises
- analysing, with an analysis device, the signal output from the satellite test adapter using the power provided by the master test adapter, particularly the power from the electric testing signal, and/or the stored power previously provided by the master test adapter.

8. The method of one of claims 1 to 7, wherein the method further comprises
- connecting a plurality of satellite test adapters with the master test adapter, and powering, with the master test adapter, each satellite test adapter of the plurality of satellite test adapters.

9. The method of one of claims 1 to 8, wherein the method further comprises
- connecting a plurality of satellite test adapters with the master test adapter in an assembly order, and powering, with the master test adapter, each satellite test adapter of the plurality of satellite test adapters in the assembly order.

10. The method of one of claims 1 to 9, wherein the method further comprises the steps of
- providing a common ground,
- arranging the plurality of test adapters electrically connectable to the common ground, and
- closing an electrical circuit via the common ground, the master test adapter and the satellite test adapter, when powering the satellite test adapter by the master test adapter and/or emitting the electric testing signal from the master test adapter to the satellite test adapter.

11. The method of one of claims 1 to 10, wherein the method further comprises the steps of
- selecting the electric testing signal from a constant voltage, a non-constant voltage, a transient voltage, a periodic voltage, a switching on and off of a pre-selected voltage, a switching on of a pre-selected voltage for a pre-determined duration and a switching of after the pre-determined duration, and powering the satellite test adapter from the master test adapter with the selected electrical testing signal.

12. The method of one of claims 1 to 11, wherein the method further comprises the steps of
- connecting a plurality of satellite test adapters with the master test adapter, and powering each satellite test adapter of the plurality of satellite adapters with a respective previously selected electrical test signal.

13. The method of one of claims 1 to 12,
wherein the wiring connectors comprise respectively a plurality of electric wire terminals, each associated with a corresponding one of the wires,
the method comprises
- connecting respective electric wire terminals of the wires to respective testing terminals of the master test adapter,
- connecting respective electric wire terminals of the wires to respective testing terminals of the satellite test adapter,
- powering, through the power supply, the master test adapter,
- powering, by the master test adapter, the satellite test adapter through at least one of the wires, and
- testing respective electrical connections between the master test adapter and the satellite test adapter through the wires.

14. The method of one of claims 1 to 13, wherein, prior to powering, by the master test adapter, the satellite test adapter through the first wire, the method further comprises the steps of
- receiving, by the master test adapter, a command sent by a processing unit, the command comprising information relating to the powering and/or the electrical test signal.

15. The method of one of claims 1 to 14, wherein the method further comprises the steps of
- charging the power source of the satellite test adapter by the master test adapter,
- connecting a first electric wire terminal of a further wire to the testing terminal of the satellite test adapter charged by the master test adapter,
- connecting a second electric wire terminal of the further wire in the testing terminal of a further satellite test adapter,
- powering, through the charged power supply of the satellite test adapter, the satellite test adapter,
- powering, by the powered satellite test adapter, the further satellite test adapter through the further wire, and
- testing an electrical connection between the powered satellite test adapter and the further satellite test adapter through the further wire.
